# EUROPÄISCHE PATENTANMELDUNG

(11) **EP 3 671 680 A1**
(43) Veröffentlichungstag der Anmeldung: **24.06.2020**
(21) Anmeldenummer: 18213375.1
(22) Anmeldetag: 18.12.2018
(51) Int. Cl.: G08B 17/113

(54) **BRAND- ODER RAUCHMELDER**

(71) Anmelder: Siemens Schweiz AG, 8047 Zürich (CH)
(72) Erfinder: Stäger, Mathias, 6313 Menzingen (CH); Vollenweider, Walter, 4566 Kriegstetten (CH)
(74) Vertreter: Maier, Daniel Oliver

(57) **Zusammenfassung**

Die Erfindung ist ein Brand- oder Rauchmelder (10) mit einer im Innern eines zumindest eine Meldergehäusehaube (14) umfassenden Meldergehäuses (12) angeordneten Detektionsanordnung (16), wobei die Detektionsanordnung zumindest eine Leiterplatte (18) umfasst und die Leiterplatte zumindest eine Öffnung aufweist, wobei die Meldergehäusehaube auf einer Innenseite eine Mehrzahl von radial in Richtung auf einen Melderdom (34) weisenden Gehäuselamellen (32) aufweist, wobei ein Durchmesser der Öffnung (60) größer als ein Durchmesser des Melderdoms ist und die Leiterplatte mit der Randlinie ihrer Öffnung zum Beispiel konzentrisch mit dem Melderdom der Meldergehäusehaube angeordnet ist.

## Beschreibung

Die Erfindung betrifft eine als Brand- oder Rauchmelder fungierende Vorrichtung, die im Folgenden kurz als Brand- oder Rauchmelder, mitunter auch - ohne Verzicht auf eine weitergehende Allgemeingültigkeit - nur als Brandmelder bezeichnet wird.

Brand- oder Rauchmelder sind an sich bekannt. Sie umfassen in einem Gehäuse eine Rauchdetektionseinrichtung, also eine Sensorik zu Detektion von zum Beispiel Rauchgasen oder dergleichen.

Optimierungsmöglichkeiten solcher Brandmelder bestehen zum Beispiel in Bezug auf deren konstruktiven Aufbau, eine reduzierte Teileanzahl und/oder einen günstigen Strömungsverlauf im Innern des Brandmelders.

Die hier vorgeschlagene Neuerung ist ein Brand- oder Rauchmelder mit einer im Innern eines Meldergehäuses angeordneten Detektionsanordnung, insbesondere einer Rauchdetektionsanordnung und/oder einer Gasdetektionsanordnung, wobei das Meldergehäuse zumindest ein als Meldergehäusehaube fungierendes Gehäuseteil umfasst. Die Meldergehäusehaube weist auf einer Innenseite eine Mehrzahl von radial in Richtung auf einen im Folgenden als Melderdom bezeichneten domartigen Abschnitt der Meldergehäusehaube weisenden Gehäuselamellen auf. Die Gehäuselamellen sind zur Luftführung im Innern des Meldergehäuses wirksam und bewirken eine Zwangsdurchströmung einer Messkammer im Innern des Brandmelders. Der Zugang zu der Messkammer besteht über die zumindest eine Öffnung, nämlich zum Beispiel zumindest eine Öffnung in einer von der Detektionsanordnung umfassten Leiterplatte.

Der Mittelpunkt des Melderdoms liegt vorzugsweise auf der konstruktiven Hauptachse des Brand- oder Rauchmelders (zentraler Melderdom). Diese Hauptachse verläuft als Hochachse vom "Boden" bis zur "Decke" des Meldergehäuses und durch den Mittelpunkt eines kreisförmigen Meldergehäuses des Brand- oder Rauchmelders. Allerdings ist eine solche Position des Melderdoms ausdrücklich nur eine Option. Der Mittelpunkt des Melderdoms kann auch von der Hauptachse beabstandet sein. Dann ergibt sich ein Brand- oder Rauchmelder mit einem exzentrischen Melderdom.

Im Falle einer Leiterplatte mit zumindest einer Öffnung fungiert diese als Trenn- oder Separationselement innerhalb des Brand- oder Rauchmelders. Die Leiterplatte trennt unterschiedliche Ebenen innerhalb des Brand- oder Rauchmelders voneinander. Anstelle einer Leiterplatte kann diese trennende bzw. separierende Funktion auch mittels einer Leiterplatte sowie eines zusammen mit der Leiterplatte in gleicher Ebene angeordneten zusätzlichen Flachbauteils erreicht werden. Alternativ kann diese trennende bzw. separierende Funktion auch mittels einer Leiterplatte zusammen mit einem in einer zu der Ebene mit der Leiterplatte parallelen Ebene, insbesondere in einer unmittelbar an die Ebene mit der Leiterplatte anschließenden Ebene, angeordneten zusätzlichen Flachbauteil erreicht werden. Als Flachbauteil kommt jeweils ein insbesondere ebenes Kunststoffteil in Betracht. Eine Leiterplatte zusammen mit zumindest einem solchen Flachbauteil ist damit geeignet, innerhalb des Brand- oder Rauchmelders als Ebenentrenner zu fungieren. Die Bezeichnung "Ebenentrenner" wird daher hier als Oberbegriff entweder für eine allein innerhalb des Brand- oder Rauchmelders als Trenn- oder Separationselement fungierende Leiterplatte oder für eine Kombination einer Leiterplatte mit zumindest einem Flachbauteil der oben genannten Art verwendet, wobei die Kombination innerhalb des Brand- oder Rauchmelders als Trenn- oder Separationselement fungiert.

Im Interesse einer besseren Lesbarkeit der nachfolgenden Beschreibung wird diese gleichwohl auf Basis einer allein als Ebenentrenner fungierenden Leiterplatte fortgesetzt. Bei jeder Erwähnung einer Leiterplatte ist ein Ebenentrenner, welcher die Leiterplatte und zumindest ein Flachbauteil der oben genannten Art umfasst,## anstelle der einzelnen Leiterplatte stets mitzulesen.

Bei einer Leiterplatte (einem Ebenentrenner) mit genau einer Öffnung ist dafür ein Durchmesser der Öffnung (ein größtmöglicher Abstand zweier Punkte auf einer Randlinie der Öffnung) größer als ein Durchmesser des Melderdoms und die Randlinie der Öffnung in der Leiterplatte reicht allseitig über den Melderdom (einen zentralen Melderdom oder einen Melderdom) hinaus. Bei einer speziellen Ausführungsform ist die Leiterplatte mit der Randlinie ihrer Öffnung konzentrisch mit dem Melderdom angeordnet.

Eine Leiterplatte kann anstelle einer Öffnung mehrere Öffnungen aufweisen. Die Leiterplatte weist zum Beispiel dann mehrere Öffnungen auf, wenn eine Öffnung durch Stege in mehrere Bereiche/Öffnungen unterteilt ist.

Die Definition der Lage der mehreren Öffnungen in Relation zum Melderdom bezieht sich auf eine gemeinsame Randlinie der Öffnungen, insbesondere eine gemeinsame kreislinienförmige Randlinie (die zu jeweils einer Öffnung gehörigen Stücke der Randlinie sind Kreisbögen und alle zu der Randlinie gehörigen Kreisbögen haben denselben Radius) der Öffnungen. Bei mehreren Öffnungen kann - anders als bei einer einzelnen Öffnung - nicht von einem Durchmesser gesprochen werden. Daher wird ein größtmöglicher Abstand zweier Punkte auf der o.g. gemeinsamen Randlinie betrachtet. Dieser ist größer als ein Durchmesser des Melderdoms und die Leiterplatte ist mit der gemeinsamen Randlinie mehrerer Öffnungen so angeordnet, dass diese Randlinie allseitig über den Melderdom der Meldergehäusehaube hinausreicht. Bei einer besonderen Ausführungsform ist dies realisiert, indem die Leiterplatte mit der gemeinsamen Randlinie der Öffnungen konzentrisch mit dem Melderdom angeordnet ist.

In beiden Situationen (eine Öffnung, mehrere Öffnungen) lässt die oder jede Öffnung angrenzend an den Melderdom Raum für eine Luftströmung aus einer Ebene unterhalb der Leiterplatte, nämlich der Ebene mit den als Leitelementen fungierenden Gehäuselamellen, in eine Ebene oberhalb der Leiterplatte und die dortige Messkammer. Die relativen Begriffe "unterhalb" und "oberhalb" beziehen sich auf die Leiterplatte und einen an einer Raumdecke angebrachten Brandmelder. Die Größe der Öffnung und deren Position oder die Größe der Gesamtheit der Öffnungen und deren Position erlauben die skizzierte Luftströmung in die Messkammer.

Die Leiterplatte (der Ebenentrenner) mit der zumindest einen Öffnung deckt die Gehäuselamellen ab, sodass die Leiterplatte anstelle eines ansonsten erforderlichen zusätzlichen Gehäuseteils tritt und zwei Ebenen in dem Meldergehäuse definiert.

Vorteilhafte Ausgestaltungen des Brandmelders sind Gegenstand der Unteransprüche. Dabei verwendete Rückbeziehungen innerhalb der Ansprüche weisen auf die weitere Ausbildung des Gegenstandes des in Bezug genommenen Anspruchs durch die Merkmale des jeweiligen abhängigen Anspruchs hin. Sie sind nicht als ein Verzicht auf die Erzielung eines selbständigen, gegenständlichen Schutzes für die Merkmale oder Merkmalskombinationen eines abhängigen Anspruchs zu verstehen. Des Weiteren ist im Hinblick auf eine Auslegung der Ansprüche sowie der Beschreibung bei einer näheren Konkretisierung eines Merkmals in einem abhängigen Anspruch davon auszugehen, dass eine derartige Beschränkung in den jeweils vorangehenden Ansprüchen sowie einer allgemeineren Ausführungsform des gegenständlichen Brandmelders nicht vorhanden ist. Jede Bezugnahme in der Beschreibung auf Aspekte abhängiger Ansprüche ist demnach auch ohne speziellen Hinweis ausdrücklich als Beschreibung optionaler Merkmale zu lesen.

Bei einer Ausführungsform des Brand- oder Rauchmelders weist dieser eine Leiterplatte (einen Ebenentrenner) mit einer kreisförmigen Außenumfangslinie auf, wobei die Randlinie der Öffnung oder die gemeinsame Randlinie mehrerer Öffnungen vorzugsweise konzentrisch mit der Außenumfangslinie ist. Die Öffnung oder die Gesamtheit der Öffnungen befindet sich dann im Zentrum der Leiterplatte. Eine solche kreisförmige Leiterplatte ist besonders leicht zu platzieren, insbesondere in oder an einem Gehäuseteil mit einer kreisförmigen Grundgeometrie, zum Beispiel einer kreisförmigen Meldergehäusehaube. Mit der oder jeder Öffnung im Zentrum der Leiterplatte ist mit einer Platzierung der Leiterplatte in dem jeweiligen Gehäuseteil die Position der oder jeder Öffnung relativ zu einem zentralen Gehäuseteil, insbesondere dem Melderdom der Meldergehäusehaube, gewährleistet.

Bei einer weiteren Ausführungsform des Brand- oder Rauchmelders weist dieser eine Leiterplatte mit mehreren kreissegment- oder kreissektorförmigen oder im Wesentlichen kreissegment- oder kreissektorförmigen Öffnungen mit einer gemeinsamen Randlinie auf. Diese mehreren Öffnungen ergeben sich, indem eine Öffnung durch einen Steg oder mehrere Stege in einzelne Bereiche geteilt wird. Jeder Bereich ist eine eigene Öffnung in der Leiterplatte. Jeder Steg zwischen zwei benachbarten Öffnungen dieser Art kommt als Ort für eine Sensorik, zum Beispiel eine Sensorik in Form zumindest eines temperaturempfindlichen Sensors, in Betracht. Die Ausführungsform des Brand- oder Rauchmelders zeichnet sich entsprechend neben dieser speziellen Form der Öffnung dadurch aus, dass zumindest ein derartiger Steg zumindest einen Sensor trägt, insbesondere einen als Temperatursensor fungierenden Sensor. Die Platzierung einer Sensorik auf zumindest einem Steg bedeutet, dass die Sensorik direkt über dem Bereich platziert ist, in dem Luft aus der Ebene unterhalb der Leiterplatte in die Ebene oberhalb der Leiterplatte und die dortige Messkammer strömt.

Bei einer speziellen Ausführungsform eines Brand- oder Rauchmelders mit dieser speziellen Form der Öffnung trägt jeder jeweils zwei benachbarte Öffnungen gegeneinander abgrenzende Steg jeweils zumindest einen temperaturempfindlichen Sensor. Dann lässt sich eine räumliche Temperaturverteilung im Bereich des Übergangs aus der Ebene unterhalb der Leiterplatte in die Ebene oberhalb der Leiterplatte und die dortige Messkammer ermitteln. Die räumliche Temperaturverteilung ist im Brandfalle ein Indiz für eine Position des Brandherds ausgehend von der Position des Brand- oder Rauchmelders.

Eine alternative Möglichkeit zur Platzierung einer Sensorik, insbesondere einer temperatursensitiven Sensorik, im Bereich des Übergangs aus der Ebene unterhalb der Leiterplatte in die Ebene oberhalb der Leiterplatte und die dortige Messkammer besteht darin, dass bei einem Brand- oder Rauchmelder mit mehreren kreissegment- oder kreissektorförmigen Öffnungen mit einer gemeinsamen Randlinie und jeweils einem Steg zwischen zwei benachbarten Öffnungen diese Stege ein Mittelstück tragen. Bei einer speziellen Ausführungsform tragen die Stege ein mit der gemeinsamen Randlinie der Öffnungen konzentrisches Mittelstück und der Mittelpunkt des Mittelstücks fällt mit dem Mittelpunkt der gemeinsamen Randlinie der Öffnungen zusammen. Dann befinden sich das Mittelstück und eine dortige Sensorik, zum Beispiel eine Sensorik in Form eines Temperatursensors oder eine Sensorik, welche zumindest einen Temperatursensor umfasst, im Zentrum des Bereichs des Übergangs zwischen den beiden genannten Ebenen.

Bei einer nochmals weiteren Ausführungsform eines in grundsätzlich an sich bekannter Art und Weise ein Kammerteil umfassenden Brand- oder Rauchmelders sind die Meldergehäusehaube und das Kammerteil miteinander kombinierbar, insbesondere lösbar kombinierbar. Bevorzugt handelt es sich bei der Meldergehäusehaube und dem Kammerteil um die einzigen Gehäuseteile des Brand- oder Rauchmelders. Das Kammerteil weist Wandabschnitte auf, welche zusammen eine Messkammer mit einer zur Meldergehäusehaube offenen Seite bilden. Ein separates Gehäuseteil zum Zwecke der Begrenzung der Messkammer ist folglich nicht erforderlich. Die zur Meldergehäusehaube offene Seite der Messkammer liegt bevorzugt in einer Ebene mit der Leiterplatte. Dann deckt die Leiterplatte die Messkammer und/oder weitere mittels von dem Kammerteil ausgehender Wandabschnitte gebildete Ausnehmungen, beispielsweise für LEDs und/oder zumindest eine Photodiode, ab.

Das Innere der Messkammer ist mittels der oder jeder Öffnung in der Leiterplatte fluidisch mit der Umgebung des Brand- oder Rauchmelders gekoppelt. Brand- oder Rauchgase können in die Messkammer (Melderkammer) eintreten und die Messkammer kann von solchen Gasen durchströmt werden.

Indem das Kammerteil die Messkammer bei einer Ausführungsform des Brand- oder Rauchmelders auf der von der Meldergehäusehaube abgewandten Seite abschließt, ist für einen solchen Abschluss kein separates Gehäuseteil erforderlich, also kein als Deckel der Messkammer fungierendes Gehäuseteil oder dergleichen.

Bei einer vorteilhaften Ausführungsform des Brand- oder Rauchmelders ist die oder jede Öffnung in der Leiterplatte mittelbar oder unmittelbar mittels eines Insektenschutzelements abgedeckt, insbesondere mittels eines Insektenschutzelements in Form eines Insektengitters, so dass Insekten oder dergleichen nicht bis in die Messkammer eindringen und zum Beispiel fälschlich einen Alarm auslösen können.

Bei einer weiteren vorteilhaften Ausführungsform des Brand- oder Rauchmelders weist dieser zumindest ein Insektenschutzelement auf, insbesondere ein Insektenschutzelement in Form eines Insektengitters, welches entlang einer geschlossenen Linie angeordnet ist, insbesondere entlang einer Kreislinie mit einem Durchmesser, welcher größer als der größtmögliche Abstand zweier Punkte auf einer Randlinie der Öffnung in der Leiterplatte oder auf einer gemeinsamen Randlinie mehrerer Öffnungen in der Leiterplatte ist. Das Insektenschutzelement befindet sich damit unterhalb der Leiterplatte und außerhalb des Bereichs der oder jeder Öffnung. In Bezug auf einen Luftstrom in die Messkammer hinein befindet sich das Insektenschutzelement stromaufwärts der oder jeder Öffnung und vermag in dieser Position wirksam zu verhindern, dass Insekten oder dergleichen über die oder jede Öffnung in die Messkammer eindringen und zum Beispiel fälschlich einen Alarm auslösen können. In der Ebene unterhalb der Leiterplatte mit den dortigen Gehäuselamellen grenzt das Insektenschutzelement einerseits an die Innenseite der Meldergehäusehaube und andererseits an die Leiterplatte an. Dafür weist das Insektenschutzelement von der Innenseite der Meldergehäusehaube ausgehend eine Höhe entsprechend einer Höhe der Lamellen auf der Innenseite der Meldergehäusehaube auf, so dass das Insektenschutzelement die lichte Höhe der Ebene unterhalb der Leiterplatte abdeckt. Das in dieser Ebene entlang einer geschlossenen Linie, insbesondere Kreislinie, angeordnete Insektenschutzelement schneidet dabei jede zum Beispiel an der Innenseite der Gehäusehaube angeformte Gehäuselamelle, insbesondere senkrecht. Eine solche an der Innenseite der Gehäusehaube angeformte Gehäuselamelle ist zum Beispiel in dem Bereich, in dem das Insektenschutzelement die Gehäuselamelle schneidet, unterbrochen, sodass die Unterbrechung eine Hindurchführung des Insektenschutzelements erlaubt.

Der Vorteil des hier vorgeschlagenen Brand- oder Rauchmelders besteht darin, dass dieser räumlich klein und mit einer minimalen Anzahl von Gehäuseteilen, insbesondere in Kunststoff ausgeführten Gehäuseteilen, realisiert werden kann. Indem das Kammerteil, von dem die Wandabschnitte ausgehen, welche die einseitig offene Messkammer definieren, die Messkammer auch wie ein Deckel abschließt, ist der Brand- oder Rauchmelder "stack-effect"-dicht, d. h. eine Luftströmung kann vom Meldersockel nicht in die Messkammer eindringen.

Nachfolgend wird ein Ausführungsbeispiel der Erfindung anhand der Zeichnung näher erläutert. Einander entsprechende Gegenstände oder Elemente sind in allen Figuren mit den gleichen Bezugszeichen versehen.

Das Ausführungsbeispiel ist nicht als Einschränkung der Erfindung zu verstehen. Vielmehr sind im Rahmen der vorliegenden Offenbarung durchaus auch Ergänzungen und Modifikationen möglich, insbesondere solche, die zum Beispiel durch Kombination oder Abwandlung von einzelnen in Verbindung mit den im allgemeinen oder speziellen Beschreibungsteil beschriebenen sowie in den Ansprüchen und/oder der Zeichnung enthaltenen Merkmalen oder Verfahrensschritten für den Fachmann im Hinblick auf die Lösung der Aufgabe entnehmbar sind und durch kombinierbare Merkmale zu einem neuen Gegenstand führen.

Es zeigen
- FIG 1: einen Brand- oder Rauchmelder,
- FIG 2: ein Gehäuseteil, nämlich eine Gehäusehaube, des Brand- oder Rauchmelders,
- FIG 3: ein weiteres Gehäuseteil, nämlich ein Kammerteil, des Brand- oder Rauchmelders, und eine damit verbundene Leiterplatte,
- FIG 4: das Kammerteil mit einem Blick in eine im Kammerteil gebildete Messkammer,
- FIG 5: den Brand- oder Rauchmelder in einer geschnittenen Seitenansicht,
- FIG 6: den Brand- oder Rauchmelder gemäß FIG 5 mit einer Veranschaulichung einer möglichen, sich im Betrieb einstellenden Luftströmung in die Messkammer hinein und aus der Messkammer hinaus,
- FIG 7: eine mögliche Anordnung eines Insektenschutzelements in der Gehäusehaube,
- FIG 8: eine in der Gehäusehaube angeordnete und als flaches Insektenschutzelement fungierende Leiterplatte,
- FIG 9: einen Schnitt durch den Brand- oder Rauchmelder entlang einer Ebene parallel zu der Leiterplatte,
- FIG 10: mögliche Anbringungsorte von Temperatursensoren und
- FIG 11: eine spezielle Anbringungsmöglichkeit eines Temperatursensors.

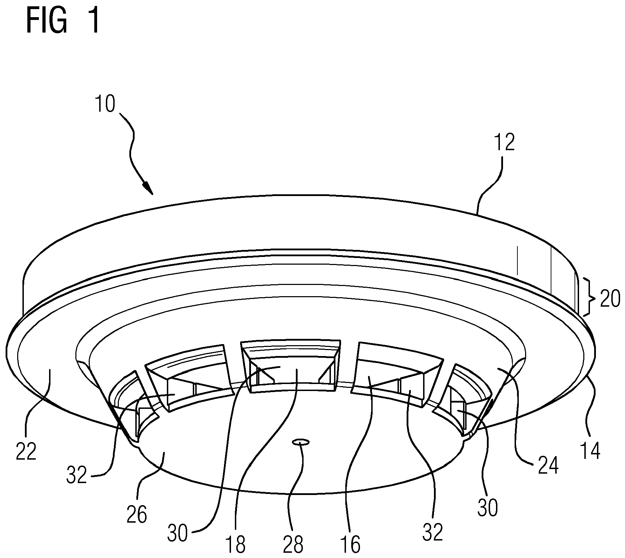

Die Darstellung in FIG 1 zeigt eine Ausführungsform eines hier vorgeschlagenen, im Folgenden kurz, aber ohne Verzicht auf eine weitergehende Allgemeingültigkeit als Brandmelder 10 bezeichneten Brand- oder Rauchmelders. In der Darstellung in FIG 1 ist der Brandmelder 10 in einer Orientierung und einer Perspektive gezeigt, wie sie sich ergibt, wenn der Brandmelder 10 an einer Decke eines Raums in einem Gebäude angebracht ist.

Von dem Brandmelder 10 ist in der Darstellung in FIG 1 ein Teil eines Gehäuses (Meldergehäuse 12), nämlich ein im Folgenden als Meldergehäusehaube 14 oder kurz als Gehäusehaube 14 bezeichneter Gehäuseteil erkennbar. Im Innern des Meldergehäuses 12 befindet sich eine grundsätzlich an sich bekannte Detektionsanordnung 16. Die Detektionsanordnung 16 umfasst eine Leiterplatte 18. In der Darstellung in FIG 1 ist von der Detektionsanordnung 16 nur ein Teil der Leiterplatte 18 erkennbar.

Bei der gezeigten Ausführungsform hat die Gehäusehaube 14 in grundsätzlich optionaler Art und Weise eine kreisförmige Basisfläche und weist einen zylindrischen Abschnitt 20 ("Meldersockel"), einen daran anschließenden ersten flachen Abschnitt 22, einen wiederum daran anschließenden konischen Abschnitt 24 und schließlich einen weiteren flachen Abschnitt 26 auf. In der Fläche des weiteren flachen Abschnitts 26, insbesondere im Zentrum dieser Fläche, befindet sich eine Signalisierungsöffnung 28.

Der konische Abschnitt 24 weist umlaufend eine Mehrzahl von Lufteintrittsöffnungen 30 auf. Im Interesse der Übersichtlichkeit der Darstellung sind nur einzelne Lufteintrittsöffnungen 30 mit Bezugslinien und Bezugsziffern bezeichnet. An die Lufteintrittsöffnungen 30 schließen Gehäuselamellen 32 an, die sich auf der Innenseite der Gehäusehaube 14 auf der Fläche des weiteren flachen Abschnitts 26 erheben. Auch hier sind im Interesse der Übersichtlichkeit der Darstellung nur einzelne bezeichnet.

Auf seiner Außenoberfläche ist bei der gezeigten Ausführungsform der konische Abschnitt 24 in grundsätzlich optionaler Art und Weise in etwa zweigeteilt. Eine untere Hälfte weist die Lufteintrittsöffnungen 30 auf. Eine obere Hälfte ist nach außen geschlossen. Etwa auf der Höhe einer gedachten Trennlinie zwischen diesen beiden Hälften befindet sich im Innern des Meldergehäuses 12 und im Innern der Gehäusehaube 14 die Leiterplatte 18 oder allgemein ein Ebenentrenner 18. Ein Ebenentrenner 18 umfasst zumindest die Leiterplatte 18 und optional zum Beispiel zumindest ein mit der Leiterplatte 18 in gleicher Ebene angeordnetes, insbesondere mit der Leiterplatte 18 kombiniertes, zusätzliches Flachbauteil, zum Beispiel ein Flachbauteil in Form eines ebenen Kunststoffteils. Die Leiterplatte 18 und das oder jedes Flachbauteil bilden zusammen in einer Ebene eine geschlossene Fläche. Bei einer allein als Ebenentrenner 18 fungierenden Leiterplatte 18 hat diese eine äußere Randlinie entsprechend der Form der Gehäusehaube 14, also zum Beispiel eine kreisförmige Randlinie. Bei einer Kombination der Leiterplatte 18 mit zumindest einem weiteren Flachbauteil zu einem Ebenentrenner 18 kann die Leiterplatte 18 eine grundsätzlich beliebige Außenkontur aufweisen, zum Beispiel rechteckig, dreieckig, halbkreisförmig, polygonal etc.

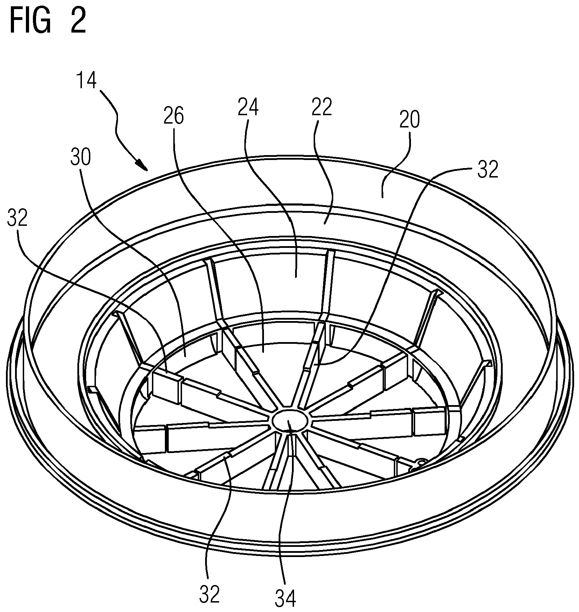

Die Darstellung in FIG 2 zeigt die Gehäusehaube 14 ohne weitere Komponenten des Brandmelders 10 und in einer Orientierung, bei welcher der Blick in das Innere der Gehäusehaube 14 frei wird. Erkennbar sind dabei der zylindrische Abschnitt 20, der erste flache Abschnitt 22, der konische Abschnitt 24 mit den Lufteintrittsöffnungen 30 an dessen unterem Ende und der weitere flache Abschnitt 26. Die Darstellung in FIG 2 lässt besonders gut erkennen, dass die Gehäusehaube 14 - wie bereits erwähnt - auf der Innenseite, hier ausgehend von der zum Gehäuseinneren gewandten Oberfläche des weiteren flachen Abschnitts 26, eine Mehrzahl von radial in Richtung auf einen zentralen Abschnitt der Gehäusehaube 14 weisenden Gehäuselamellen 32 aufweist. Der zentrale Abschnitt ist ein hohlzylindrischer Abschluss der Gehäuselamellen 32 und wird im Folgenden entsprechend der üblichen Fachterminologie als Melderdom 34 bezeichnet. Bei der gezeigten Ausführungsform fällt der Mittelpunkt des Melderdoms 34 mit der (nicht gezeigten) Hauptachse des Brandmelders 10 zusammen (zentraler Melderdom 34). Anstelle eines zentralen Melderdoms 34 ist auch ein exzentrischer Melderdom 34 möglich. Eine Variante mit einem exzentrischen Melderdom 34 ist im Folgenden stets mitzulesen.

Bei der gezeigten Ausführungsform schließt an jede Lufteintrittsöffnung 30 beidseitig jeweils eine randseitig von der Lufteintrittsöffnung 30 ausgehende Gehäuselamelle 32 an. Dies ist eine bevorzugte Ausführungsform und andere Konfigurationen sind ebenso denkbar. Beispielsweise eine Konfiguration, bei der an zwei oder mehr einander benachbarte Lufteintrittsöffnungen 30 jeweils eine randseitig von jeweils einer Lufteintrittsöffnung 30 ausgehende Gehäuselamelle 32 anschließt. Genauso ist denkbar, dass innerhalb der Fläche einer Lufteintrittsöffnung 30 eine Gehäuselamelle 32 beginnt.

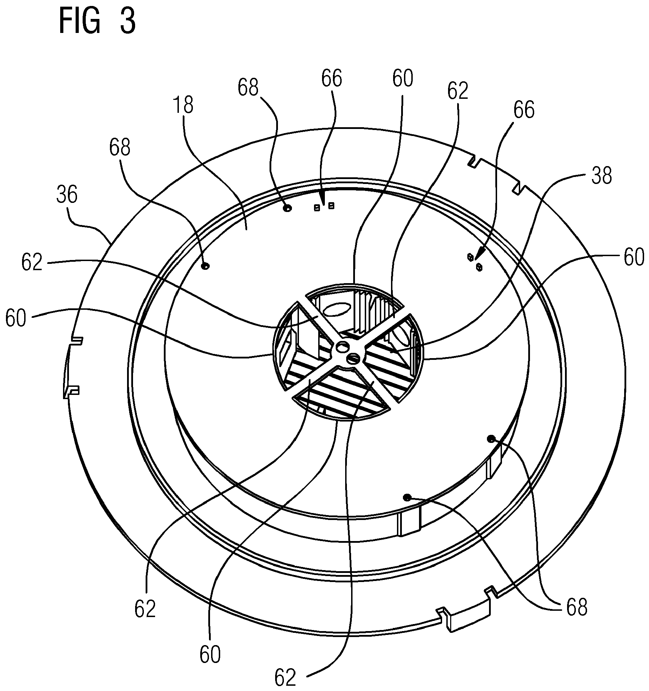

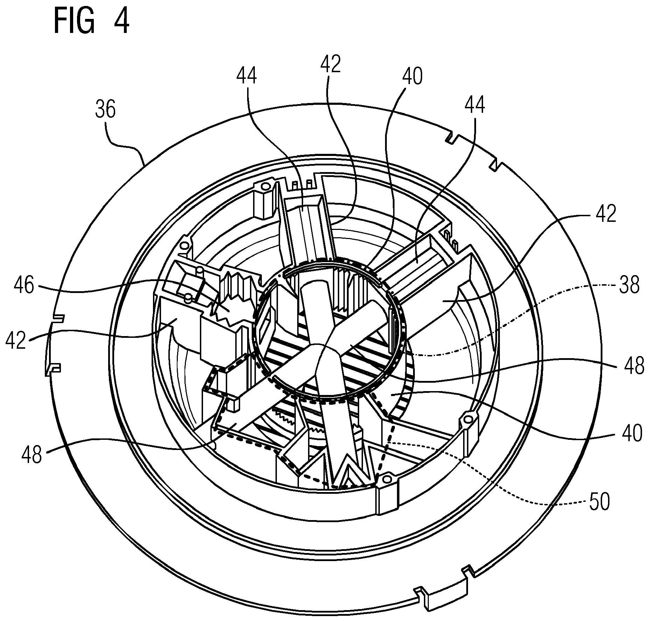

Die Darstellungen in FIG 3 und FIG 4 zeigen ein weiteres Gehäuseteil des Brandmelders 10. In der Darstellung in FIG 3 ist mit diesem - in einer Orientierung parallel zu einer Hauptebene des Gehäuseteils - die Leiterplatte 18 verbunden. Dieses weitere Gehäuseteil wird im Folgenden als Meldergehäusekammerteil oder kurz als Kammerteil 36 bezeichnet. Das Kammerteil 36 bildet zusammen mit der Leiterplatte 18 die Messkammer 38 (und einen Lichtsumpf 50; FIG 4) des Brandmelders 10. An einigen Stellen liegt die Leiterplatte 18 auf dem Kammerteil 36 auf. An anderen Stellen wiederum nicht, nämlich im Bereich der Messkammer 38.

Die Gehäusehaube 14 ist mit dem Kammerteil 36 kombinierbar, zum Beispiel lösbar verbindbar, insbesondere rastend lösbar verbindbar, zum Beispiel mittels eines Schnappers und einem entsprechenden Gegenprofil in oder an der Gehäusehaube 14 bzw. in oder am Kammerteil 36. Nicht lösbare Verbindungen, wie zum Beispiel eine Verbindung mittels Ultraschallschweißen, sind alternativ ebenfalls möglich.

Die Darstellung in FIG 4 zeigt das Kammerteil 36 ohne die Leiterplatte 18. Hier ist erkennbar, dass das Kammerteil 36 Wandabschnitte 40, insbesondere strukturierte Wandabschnitte 40, aufweist, welche zusammen eine zur Gehäusehaube 14 offene Messkammer 38 bilden (weitere Wandabschnitte 40 bilden Teile des Lichtsumpfs 50; FIG 4). Zu den Wandabschnitten 40 gehören auch Abschnitte von Aufnahmen 42 für zumindest eine LED 44 oder dergleichen sowie für zumindest eine Photodiode 46, die mittels der Leiterplatte 18 abgedeckt werden (wie dies in der Darstellung in FIG 3 gezeigt ist). Die oder jede LED 44 und Photodiode 46 sowie eine nicht gezeigte, grundsätzlich an sich bekannte Elektronik auf der Leiterplatte 18 bilden zusammen eine als Rauchdetektionsanordnung fungierende Detektionsanordnung 16.

In der Darstellung in FIG 4 ist ein Strahlgang im Innern der Messkammer 38 gezeigt. Von den (bei der gezeigten Ausführungsform um 60° zueinander versetzten) LEDs 44 ausgehende Strahlen 48 enden in einem den LEDs 44 an der Messkammer 38 gegenüberliegenden, lichtabsorbierenden sogenannten Lichtsumpf 50 (Labyrinth). Im Falle von in die Messkammer 38 eintretenden Rauchpartikeln oder dergleichen wird die Strahlung der LEDs 44 in grundsätzlich an sich bekannter Art gestreut und aufgrund einer solchen Streuung gelangt das Licht zumindest zum Teil zu der zumindest einen Photodiode 46, sodass die Rauchentwicklung detektiert ist. In diesem Falle kann zum Beispiel ein auf der Leiterplatte 18 platziertes Anzeigeelement, zum Beispiel eine LED (nicht gezeigt), aktiviert werden, deren Lichtsignal oder deren Lichtsignale mittels eines durch einen hohlzylindrischen Melderdom 34 sowie durch die Signalisierungsöffnung 28 hindurchreichenden Lichtleiters zur Außenseite des Brandmelders 10 geleitet wird bzw. werden.

Der Eintritt solcher Rauchpartikel oder dergleichen in die im Kammerteil 36 gebildete Messkammer 38 erfolgt durch eine zur Gehäusehaube 14 offene Seite der Messkammer 38. Diese offene Seite liegt in der Ebene der Leiterplatte 18 (oder in der Ebene eines zumindest die Leiterplatte 18 umfassenden Ebenentrenners 18) und ergibt sich aufgrund zumindest einer Öffnung 60 in der Leiterplatte 18 (oder in einem die Leiterplatte 18 umfassenden Ebenentrenner 18).

Bei einer allein als Ebenentrenner 18 fungierenden Leiterplatte 18 weist diese die oder jede Öffnung 60 auf, so wie dies in den Figuren gezeigt ist. Bei einem die Leiterplatte 18 umfassenden Ebenentrenner 18 kann sich die Öffnung 60 zumindest zum Teil auch in einem neben der Leiterplatte 18 zu dem Ebenentrenner 18 gehörenden Flachbauteil befinden und bei mehreren Öffnungen 60 können sich einzelne Öffnungen 60 ganz oder teilweise einerseits in der Leiterplatte 18 und andererseits in dem Flachbauteil oder einem Flachbauteil befinden. Die ist bei der weiteren Beschreibung stets mitzulesen und zu berücksichtigen, die - im Interesse besserer Lesbarkeit - anhand einer allein als Ebenentrenner 18 fungierenden Leiterplatte 18 fortgesetzt wird.

In der Darstellung in FIG 3 ist exemplarisch eine Ausführungsform mit einer Leiterplatte 18 mit vier gleich großen Öffnungen 60 gezeigt. Die Öffnungen 60 sind kreissektorförmig und zwischen jeweils zwei benachbarten Öffnungen 60 verbleibt ein Steg 62, wobei sich alle Stege 62 mittig treffen, nämlich in einem Mittelstück 64. Die Gesamtheit der Öffnungen 60 kann auch als eine Öffnung 60 angesehen werden, welche durch einen Steg 62 oder mehrere Stege 62 in verschiedene Bereiche unterteilt wird.

Bei der gezeigten Ausführungsform ist die Leiterplatte 18 kreisförmig und relativ zu dem ebenfalls kreisförmigen Kammerteil 36 mittig angeordnet. Die vier Öffnungen 60 bilden (zusammen betrachtet) einen kreisförmigen Ausschnitt im Zentrum der Leiterplatte 18 und entsprechend der Anordnung der Leiterplatte 18 relativ zu dem Kammerteil 36 und der Position des Ausschnitts in der Gesamtfläche der Leiterplatte 18 befindet sich dieser Ausschnitt mittig über dem Kammerteil 36 (und damit mittig unter dem Zentrum der Gehäusehaube 14).

Der genannte kreisförmige Ausschnitt kann in Form einer einzelnen kreisförmigen Öffnung 60 bestehen oder - wie gezeigt - in Form einer kreisförmigen Öffnung 60, welche durch Stege 62 in verschiedene Bereiche unterteilt wird. Wenn diese Bereiche jeweils als eigene Öffnungen 60 angesehen werden, haben deren äußere Randlinien jeweils denselben Radius und liegen allesamt auf ein und derselben Kreislinie. Diese Kreislinie wird als gemeinsame Randlinie mehrerer Öffnungen 60 bezeichnet. Gegebenenfalls mit Rauchpartikeln oder dergleichen beladene Umgebungsluft gelangt ausgehend von der Ebene mit den Lamellen 32 durch die oder jede Öffnung 60 in der Leiterplatte 18 in die Ebene mit der Messkammer 38. Bei einer einzelnen kreisförmigen Öffnung 60 ist deren Durchmesser dafür größer als der Durchmesser des Melderdoms 34 der Gehäusehaube 14. Bei einer kreisförmigen Öffnung 60, welche durch Stege 62 in verschiedene Bereiche unterteilt wird, ist dafür ebenfalls deren Durchmesser größer als der Durchmesser des Melderdoms 34 der Gehäusehaube 14. Bei einer Betrachtung solcher Bereiche jeweils als einzelne Öffnungen 60 gilt dies entsprechend. Dann ist ein größtmöglicher Abstand zweier Punkte auf einer gemeinsamen Randlinie dieser Öffnungen 60 größer als der Durchmesser des Melderdoms 34. Aufgrund dieses Verhältnisses (Durchmesser Öffnung 60 zu Durchmesser Melderdom 34 bzw. maximaler Abstand auf der Randlinie zu Durchmesser Melderdom 34) bleibt seitlich angrenzend an den Melderdom 34 Raum zum Übertritt eines Luftstroms aus der Ebene mit den Lamellen 32 in die Messkammer 38. Wenn der Luftstrom Rauchpartikel oder dergleichen mitführt, wird dies dort (wie oben skizziert) detektiert.

In der Darstellung in FIG 3 sind auf der Oberfläche der Leiterplatte 18 einzelne Kontaktstellen 66, 68 gezeigt, nämlich Kontaktstellen 66 für zum Beispiel Lötkontakte zur Kontaktierung der LEDs 44 und Kontaktstellen 68 für zum Beispiel Lötkontakte für Sockelkontakte.

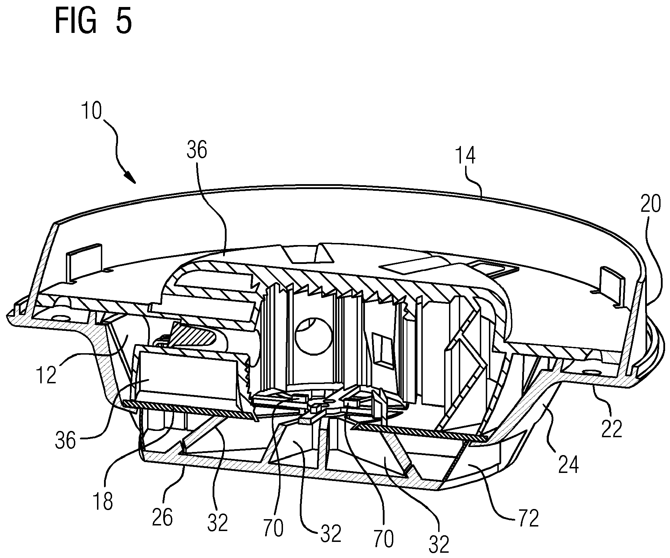

Die Darstellung in FIG 5 zeigt eine Schnittdarstellung des Brandmelders 10 mit einer Schnittebene parallel zu dessen Hochachse. Das Kammerteil 36 ist mit der Gehäusehaube 14 verbunden. Die Verbindung ist mittels einzelner randseitig vom Kammerteil 36 ausgehender Rastlaschen mit Rastnasen an deren freien Enden hergestellt, die in entsprechender Ausnehmungen in der Innenseite des zylindrischen Abschnitts 20 der Gehäusehaube 14 eingreifen.

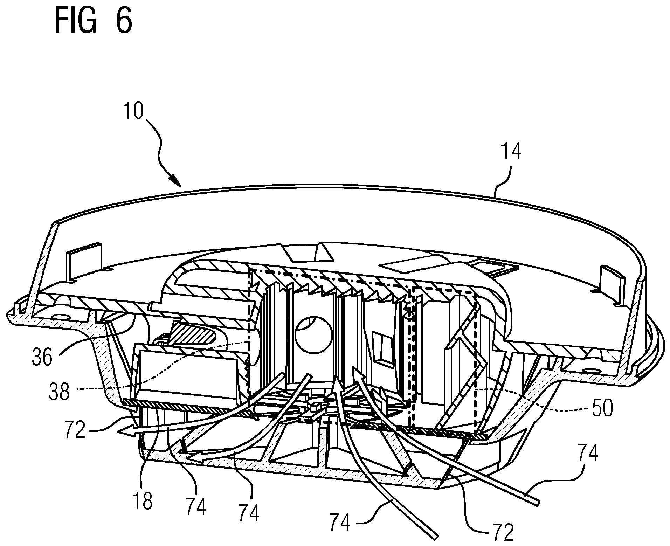

In der Darstellung in FIG 5 sind aufgrund des Schnitts die zuvor erwähnten unterschiedlichen Ebenen, nämlich eine Ebene mit den Gehäuselamellen 32 und eine Ebene mit der Messkammer 38 (FIG 4, FIG 6), gut erkennbar. Die Leiterplatte 18 bildet die Grenze zwischen diesen beiden Ebenen. Auf den Stegen 62 befinden sich sensorisch wirksame elektronische Bauteile (Sensorik), nämlich Temperatursensoren 70, insbesondere Halbleiter-Temperatursensoren (NTC). Grundsätzlich ist eine Konfiguration denkbar, bei der sich - wie gezeigt - auf jedem Steg 62 genau ein oder zumindest ein Temperatursensor 70 befindet. Alternativ ist auch eine Konfiguration möglich, bei der sich nur auf einzelnen Stegen 62 genau ein oder zumindest ein Temperatursensor 70 befindet. Bei mehreren Temperatursensoren 70 ist bevorzugt eine zum Melderdom 34 symmetrische Platzierung vorgesehen. Die Temperatursensoren 70 können - wie gezeigt - auf der Bestückungsseite der Leiterplatte 18 (auf der in Richtung auf das Kammerteil 36 weisenden Oberfläche) oder auf der anderen Oberfläche der Leiterplatte 18 platziert sein.

Die Lufteintrittsöffnungen 30 im konischen Abschnitt 24 der Gehäusehaube 12 sind mittels eines Insektenschutzelements 72 verschlossen. Als Insektenschutzelement 72 fungiert ein Gewebe oder eine gitter- oder netzartige Struktur mit Öffnungen, welche in an sich bekannter Art und Weise einen ungehinderten Durchtritt von Umgebungsluft sowie von davon ggf. mitgeführten Rauchpartikeln oder dergleichen erlauben, aber zum Beispiel Insekten vom Innern des Brandmelders 10 fernhalten.

Die Darstellung in FIG 6 zeigt (in derselben Perspektive wie FIG 5 und mit derselben Schnittebene) eine mögliche, sich bei der Verwendung des Brandmelders 10 einstellende Luftströmung 74 in die Messkammer 38 hinein und aus der Messkammer 38 hinaus.

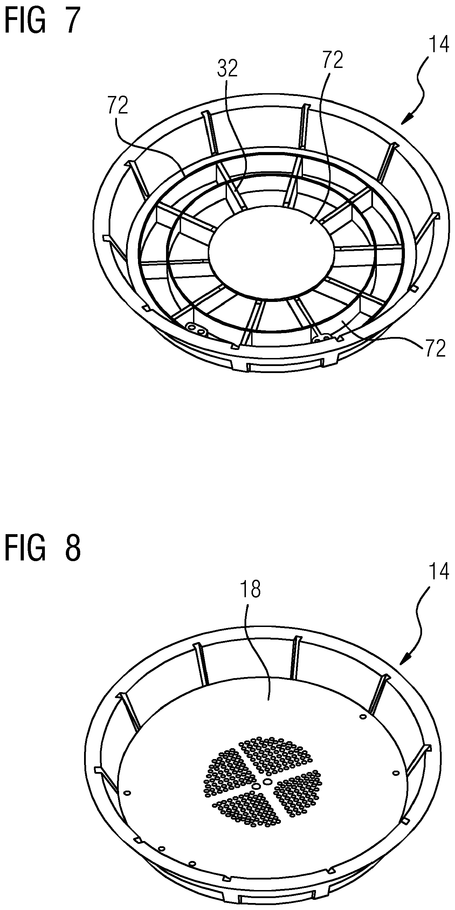

Die Darstellung in FIG 7 zeigt eine mögliche Anordnung des Insektenschutzelements 72 im Innern der Gehäusehaube 14. Das Insektenschutzelement 72 kann - wie in FIG 7 und auch in FIG 6 gezeigt - entlang einer geschlossenen Kreislinie unmittelbar im Anschluss an die Lufteintrittsöffnungen 30 platziert sein. Genauso kann das Insektenschutzelement 72 weiter in Richtung des (in der Darstellung in FIG 7 nicht sichtbaren) Melderdoms 34 und ebenso entlang einer geschlossenen Kreislinie platziert sein. Das Insektenschutzelement 72 sperrt damit jeden Luftweg zwischen jeweils zwei benachbarten Gehäuselamellen 32 für Insekten oder dergleichen in das Innere des Brandmelders 10 und die dortige Messkammer 38. Zusätzlich oder alternativ kann auch - wie in FIG 7 gezeigt - ein flaches Insektenschutzelement 72 vorgesehen sein, welches die Öffnung 60 oder alle Öffnungen 60 in der Leiterplatte 18 abdeckt. Zur Aufnahme eines flachen Insektenschutzelements 72 zwischen den Oberkanten der Gehäuselamellen 32 und der Leiterplatte 18 weisen die Gehäuselamellen 32 in ihren Oberkanten bevorzugt ein Stufenprofil mit jeweils zumindest einer Stufe auf, wie dies besonders gut in der Darstellung in FIG 2 erkennbar ist.

Als Insektenschutzelement 72 kann auch die Leiterplatte 18 selbst fungieren - wie in FIG 8 gezeigt. Dann weist diese im Bereich der oder jeder Öffnung 60 kleinere "Löcher" (Öffnungen, Bohrungen, Ausnehmungen) auf, welche in ihrer Gesamtheit nach Art eines Netzes einen Durchtritt einer Luftströmung erlauben. Insekten oder dergleichen werden zurückgehalten.

Alternativ zu einem flachen Insektenschutzelement 72 kommt auch ein konusförmiges oder korbförmiges Insektenschutzelement 72 in Betracht. Ein solches Insektenschutzelement 72 umfasst einen flachen Mittelabschnitt, welcher mit der Innenseite der Gehäusehaube 14 in Kontakt ist, und einen Randabschnitt, welcher sich randständig vom Mittelabschnitt bis zur Leiterplatte 18 in einem Winkel von beispielsweise 45° erhebt. Dann ergibt sich ein in seiner Hüllkontur konisches Insektenschutzelement 72 oder bei leichter Deformation ein korbförmiges Insektenschutzelement 72.

Genau ein Insektenschutzelement 72 der gezeigten Art ist ausreichend. Mehrere Insektenschutzelemente 72 sind möglich. Anstelle eines separaten Insektenschutzelements 72 kommt auch eine Gestaltung der Öffnung 60 in der Leiterplatte 18 in Form einer Gitterstruktur in Betracht, wie dies in der Darstellung in FIG 8 gezeigt ist.

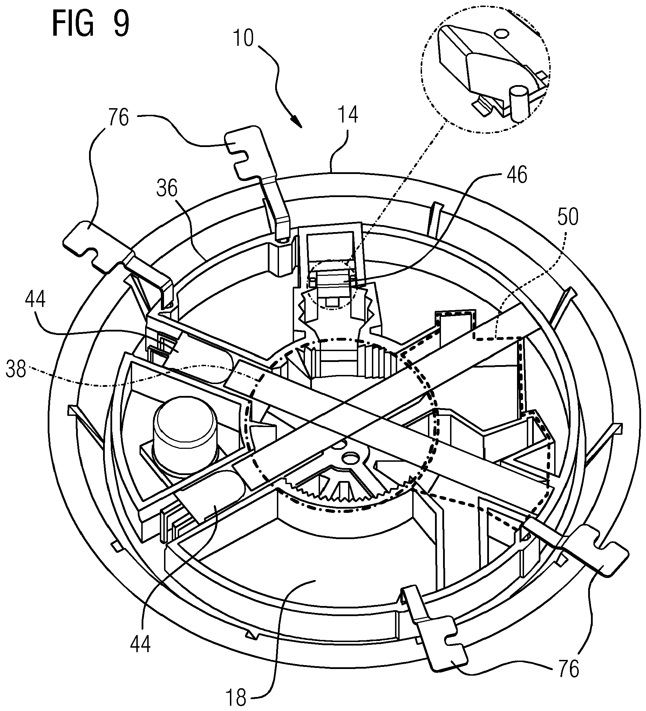

Die Darstellung in FIG 9 zeigt einen horizontalen Schnitt durch den Brandmelder 10. Die Leiterplatte 18 ist bevorzugt im Bereich der Messkammer 38 und im Bereich des Lichtsumpfs 50 schwarz. Der Photodiode 46 ist bevorzugt eine Linse zugeordnet, welches in der Messkammer 38 gestreutes, einfallendes Licht um 90° in die Ebene der Leiterplatte 18 umlenkt, sodass die Photodiode 46 mit ihrer sensorisch wirksamen Oberfläche parallel zur Oberfläche der Leiterplatte 18 anordenbar ist (SMD-Bauteil). Ausgehend von einer randseitigen Wand des Kammerteils 36 sind Sockelkontaktfahnen 76 gezeigt, welche (insbesondere einstückig) an stiftförmige Leiterelemente anschließen, die in die Wandung des Kammerteils 36 eingebettet sind und mittels der Kontaktstellen 68 (FIG 3) elektrisch leitend mit der Schaltung auf der Leiterplatte 18 verbunden sind. Mittels mindestens zweier Sockelkontaktfahnen 76 erfolgen die Zuführung elektrischer Energie zur Leiterplatte 18 und der Anschluss der Leiterplatte 18 an ein weiterführendes Netzwerk, nämlich ein Netzwerk zur Weiterleitung zumindest eines Signals von dem Brandmelder 10 zum Beispiel zu einer übergeordneten Brandmeldezentrale.

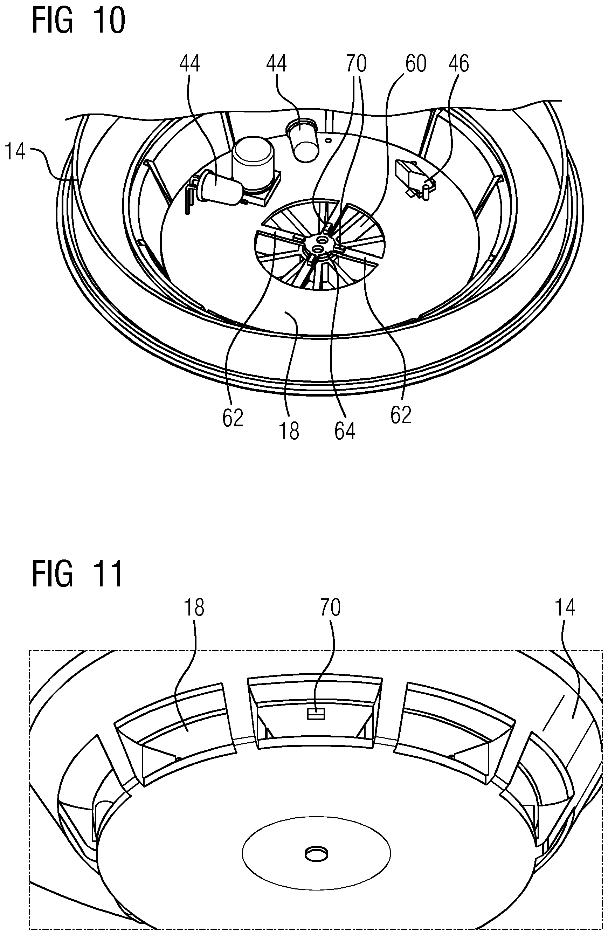

Die Darstellung in FIG 10 zeigt mögliche Positionen einer Sensorik zur Erfassung von Temperaturmesswerten, und zwar die bereits im Zusammenhang mit der Beschreibung von FIG 5 erläuterte Position der Temperatursensoren 70 auf den Stegen 62 der Leiterplatte 18, also eine Position der Temperatursensoren 70 im Zentrum der Leiterplatte 18 und im Bereich der Messkammer 38. Zusätzlich oder alternativ kann zumindest ein Temperatursensor 70 auch auf dem von den Stegen 62 getragenen Mittelstück 64 platziert sein. Das Mittelstück 64 kommt ebenfalls als Ort der Anbringung eines als Alarmindikator fungierenden Anzeigeelements (LED oder dergleichen) in Betracht. Das Anzeigeelement befindet sich dann im Bereich der Hauptachse des Brandmelders 10.

Die Darstellung in FIG 11 zeigt im Gegensatz zu einer Anbringung zumindest eines Temperatursensors 70 auf zumindest einem Steg 62 oder dem Mittelstück 64 eine randseitige (randseitig in Bezug auf die Leiterplatte 18) Platzierung der Temperatursensoren 70. Auch hier ist bevorzugt eine symmetrische Verteilung der Temperatursensoren 70 vorgesehen, zum Beispiel eine regelmäßig entlang der Umfangslinie der Leiterplatte 18 verteilte Anordnung von drei, vier, fünf usw. Temperatursensoren 70.

Obwohl die hier vorgeschlagene Neuerung im Detail durch das Ausführungsbeispiel näher illustriert und beschrieben wurde, so ist die Erfindung nicht durch das offenbarte Beispiel eingeschränkt und andere Variationen können vom Fachmann hieraus abgeleitet werden, ohne den Schutzumfang der Erfindung zu verlassen.

Einzelne im Vordergrund stehende Aspekte der hier eingereichten Beschreibung lassen sich damit kurz wie folgt zusammenfassen: Angegeben wird ein Brand- oder Rauchmelder 10 mit einer im Innern eines Meldergehäuses 12 angeordneten Detektionsanordnung 16, wobei das Meldergehäuse 12 zumindest eine Meldergehäusehaube 14 umfasst. Die Detektionsanordnung 16 umfasst zumindest eine Leiterplatte 18 und die Leiterplatte 18 weist zumindest eine Öffnung 60 auf. Die oder jede Öffnung 60 fungiert als "Lufteinlass" in eine Messkammer 38 im Innern des Meldergehäuses 12. Zur Lenkung eines Luftstroms in die Messkammer 38 weist die Meldergehäusehaube 14 auf einer Innenseite eine Mehrzahl von radial in Richtung auf einen sogenannten Melderdom 34 weisenden Gehäuselamellen 32 auf. Die Gehäuselamellen 32 sind einstückig mit der Meldergehäusehaube 14 verbunden und ein Boden der Meldergehäusehaube 14 bildet (im Innern der Meldergehäusehaube 14) die untere Grenze der Gehäuselamellen 32. Nach oben werden die Gehäuselamellen 32 durch die Leiterplatte 18 begrenzt. Die Gehäuselamellen 32 treffen sich im Bereich des Melderdoms 34 oder treffen auf den Melderdom 34. Jedenfalls ist der Melderdom 34 ein Hindernis für den Luftstrom. Um ein Eintreten des Luftstroms trotz dieses Hindernisses in die Messkammer 38 zu ermöglichen, ist die Fläche der Öffnung 60 oder die Fläche aller Öffnungen 60 größer als die Fläche - die Projektionsfläche bei einer Projektion entlang der Hauptachse des Brand- oder Rauchmelders 10 - des Melderdoms 34. Ohne einen Bezug auf eine solche Fläche ist dies in der Beschreibung dahingehend definiert, dass ein größtmöglicher Abstand zweier Punkte auf einer Randlinie der Öffnung 60 oder auf einer gemeinsamen Randlinie mehrerer Öffnungen 60 größer als ein Durchmesser des Melderdoms 34 ist. Die Randlinie der Öffnung 60 in der Leiterplatte 18 oder die gemeinsame Randlinie mehrerer Öffnungen 60 in der Leiterplatte 18 reicht allseitig über den Melderdom 34 der Meldergehäusehaube 14 hinaus. Dies ist bei der gezeigten Ausführungsform in grundsätzlich optionaler Art und Weise dadurch realisiert, dass die Leiterplatte 18 mit der Randlinie ihrer Öffnung 60 oder der gemeinsamen Randlinie mehrerer Öffnungen 60 konzentrisch mit dem Melderdom 34 der Meldergehäusehaube 14 angeordnet ist. In beiden Fällen verbleibt rund um den Melderdom 34 Raum für einen Eintritt des Luftstroms aus der Ebene mit den Gehäuselamellen 32 durch die oder jede Öffnung 60 hindurch und in die Messkammer 38 hinein.

### Bezugszeichenliste

- 10: Brand- oder Rauchmelder, Brandmelder
- 12: Meldergehäuse
- 14: Meldergehäusehaube, Gehäusehaube (Teil des Meldergehäuses)
- 16: Detektionsanordnung
- 18: Ebenentrenner / Leiterplatte
- 20: zylindrischer Abschnitt (der Gehäusehaube)
- 22: flacher Abschnitt (der Gehäusehaube)
- 24: konischer Abschnitt (der Gehäusehaube)
- 26: weiterer flacher Abschnitt (der Gehäusehaube)
- 28: Signalisierungsöffnung
- 30: Lufteintrittsöffnung
- 32: Gehäuselamelle
- 34: Melderdom
- 36: Kammerteil (Teil des Meldergehäuses)
- 38: Messkammer
- 40: Wandabschnitt (des Kammerteils)
- 42: Aufnahme (für LED oder Photodiode)
- 44: LED
- 46: Photodiode
- 48: Strahl (Strahlgang der LED)
- 50: Lichtsumpf
- 52-58: (frei)
- 60: Öffnung (in der Leiterplatte)
- 62: Steg (in der Öffnung)
- 64: Mittelstück
- 66, 68: Kontaktstelle
- 70: Sensorik, Sensor, Temperatursensor
- 72: Insektengitter
- 74: Luftströmung
- 76: Sockelkontaktfahne
- 78: Wandabschnitt (des Kammerteils)

## Patentansprüche

1. Brand- oder Rauchmelder (10) mit einer im Innern eines Meldergehäuses (12) angeordneten Detektionsanordnung (16), wobei das Meldergehäuse (12) zumindest eine Meldergehäusehaube (14) umfasst, **dadurch gekennzeichnet,**
- **dass** die Meldergehäusehaube (14) auf einer Innenseite eine Mehrzahl von radial in Richtung auf einen Melderdom (34) weisenden Gehäuselamellen (32) aufweist,
- **dass** die Detektionsanordnung (16) zumindest einen Ebenentrenner (18) umfasst und der Ebenentrenner (18) zumindest eine Öffnung (60) aufweist,
- **dass** ein größtmöglicher Abstand zweier Punkte auf einer Randlinie der Öffnung (60) oder auf einer gemeinsamen Randlinie mehrerer Öffnungen (60) größer als ein Durchmesser des Melderdoms (34) ist und
- **dass** die Randlinie der Öffnung (60) im Ebenentrenner (18) oder die gemeinsame Randlinie mehrerer Öffnungen (60) im Ebenentrenner (18) allseitig über den Melderdom (34) der Meldergehäusehaube (14) hinausreicht.

2. Brand- oder Rauchmelder (10) nach Anspruch 1, wobei als Ebenentrenner (18) eine Leiterplatte (18) fungiert.

3. Brand- oder Rauchmelder (10) nach Anspruch 1,
- wobei als Ebenentrenner (18) eine Kombination aus einer Leiterplatte (18) und einem zusätzlichen Flachbauteil fungiert und
- wobei die Leiterplatte (18) und das Flachbauteil parallel zueinander und in derselben Ebene angeordnet sind oder
- wobei die Leiterplatte (18) und das Flachbauteil parallel zueinander und in parallelen Ebenen angeordnet sind.

4. Brand- oder Rauchmelder (10) nach einem der vorangehenden Ansprüche, wobei der Ebenentrenner (18) mit der Randlinie seiner Öffnung (60) oder der gemeinsamen Randlinie mehrerer Öffnungen (60) im Meldergehäuse (12) konzentrisch mit dem Melderdom (34) der Meldergehäusehaube (14) angeordnet ist.

5. Brand- oder Rauchmelder (10) nach einem der vorangehenden Ansprüche, mit einem Ebenentrenner (18) mit einer kreisförmigen Außenumfangslinie.

6. Brand- oder Rauchmelder (10) nach Anspruch 5, wobei die Randlinie der Öffnung (60) oder die gemeinsame Randlinie mehrerer Öffnungen (60) konzentrisch mit der kreisförmigen Außenumfangslinie ist.

7. Brand- oder Rauchmelder (10) nach einem der vorangehenden Ansprüche,
- wobei das Meldergehäuse (12) neben der Meldergehäusehaube (14) ein Kammerteil (36) umfasst,
- wobei die Meldergehäusehaube (14) mit dem Kammerteil (36) kombinierbar ist,
- wobei das Kammerteil (36) Wandabschnitte (40) umfasst, welche zusammen eine Messkammer (38) mit einer zur Meldergehäusehaube (14) offenen Seite bilden und
- wobei die zur Meldergehäusehaube (14) offene Seite der Messkammer (38) in einer Ebene mit dem Ebenentrenner (18) liegt.

8. Brand- oder Rauchmelder (10) nach Anspruch 7, wobei das Kammerteil (36) die Messkammer (38) auf der von der oder jeder Öffnung (60) abgewandten Seite abschließt.

9. Brand- oder Rauchmelder (10) nach Anspruch 7 oder 8, wobei das Innere der Messkammer (38) mittels der oder jeder Öffnung (60) im Ebenentrenner (18) fluidisch mit der Umgebung des Brand- oder Rauchmelders (10) gekoppelt ist.

10. Brand- oder Rauchmelder (10) nach einem der vorangehenden Ansprüche,
- mit mehreren kreissegment- oder kreissektorförmigen Öffnungen (60) mit einer gemeinsamen Randlinie und jeweils einem Steg (62) zwischen zwei benachbarten Öffnungen (60) und
- einer Sensorik (70) auf zumindest einem Steg (62) oder jedem Steg (62).

11. Brand- oder Rauchmelder (10) nach einem der vorangehenden Ansprüche, mit mehreren kreissegment- oder kreissektorförmigen Öffnungen (60) mit einer gemeinsamen Randlinie und jeweils einem Steg (62) zwischen zwei benachbarten Öffnungen (60), wobei die Stege (62) ein Mittelstück (64) tragen und wobei das Mittelstück (64) eine Sensorik (70) und/oder ein Anzeigeelement trägt.

12. Brand- oder Rauchmelder (10) nach Anspruch 10 oder 11, wobei die Sensorik (70) zumindest einen temperaturempfindlichen Sensor (70) umfasst.

13. Brand- oder Rauchmelder (10) nach einem der vorangehenden Ansprüche, mit einem die oder jede Öffnung (60) abdeckenden Insektenschutzelement (72).

14. Brand- oder Rauchmelder (10) nach einem der vorangehenden Ansprüche, mit zumindest einem entlang einer geschlossenen Kreislinie angeordneten Insektenschutzelement (72) mit einem Durchmesser größer als der größtmögliche Abstand zweier Punkte auf einer Randlinie der Öffnung (60) oder auf einer gemeinsamen Randlinie mehrerer Öffnungen (60), wobei das Insektenschutzelement (72) an die Innenseite der Meldergehäusehaube (14) angrenzt und von der Innenseite der Meldergehäusehaube (14) ausgehend eine Höhe entsprechend einer Höhe der Gehäuselamellen (32) auf der Innenseite der Meldergehäusehaube (14) aufweist.

15. Brand- oder Rauchmelder (10) nach einem der vorangehenden Ansprüche, mit einem in einer Ebene auf den freien Oberkanten der Gehäuselamellen (32) aufliegenden Insektenschutzelement (72).
